# EUROPEAN PATENT APPLICATION

(11) **EP 4 394 861 A1**
(43) Date of publication of application: **03.07.2024**
(21) Application number: 22860881.6
(22) Date of filing: 15.04.2022
(51) Int. Cl.: H01L 23/29, H01L 23/31, C09J 163/02, C08L 63/00, C08L 71/10, H01L 21/52, H01L 21/301, C09J 7/30

(54) **FILM-LIKE ADHESIVE AGENT, AND ELECTRONIC COMPONENT USING SAME AND METHOD FOR PRODUCING SAME**

(30) Priority: 23.08.2021 JP 2021135624
(71) Applicant: FURUKAWA ELECTRIC CO., LTD., Tokyo 100-8322 (JP)
(72) Inventor: SAKAI, Koyuki, Tokyo 100-8322 (JP); MORITA, Minoru, Tokyo 100-8322 (JP)
(74) Representative: Forstmeyer, Dietmar
(86) International application number: PCT/JP2022/017919
(87) International publication number: WO 2023/026584

(57) **Abstract**

A film adhesive containing: an epoxy resin (A); an epoxy resin curing agent (B); and a phenoxy resin (C),
wherein a content of the epoxy resin curing agent (B) in the film adhesive is 0.30 to 12.0 mass%; and
wherein a light transmittance T1 of the film adhesive at a wavelength of 400 nm is 90% or less, a light transmittance T2 of a cured product obtained by thermally curing the film adhesive at a wavelength of 400 nm is 85% or more, and T1 < T2 is satisfied.

## Description

### TECHNICAL FIELD

The present invention relates to a film adhesive, an electronic component using the same, and a method of producing the same.

### BACKGROUND ART

Imaging devices such as digital still cameras and digital video cameras incorporate image sensors (imaging elements) such as CMOS (Complementary Metal Oxide Semiconductor) image sensors and CCD (Charge Coupled Device) image sensors. The image sensor photoelectrically converts incident light into an electric signal with a photodiode, and performs signal processing to form a digital image. A color filter, a microlens, or the like is disposed on the surface of the photodiode as necessary, and a transparent protective film such as a glass plate is usually further disposed on the surface thereof. Such a transparent protective film is fixed via a film adhesive or the like. An adhesive used for bonding and fixing the transparent protective film of the image sensor is required to have transparency for sufficiently transmitting light.

The film adhesive itself is known to have various types of compositions, and is widely used in the production of not only image sensors but also electronic devices and members thereof, and the like. For example, in the process of producing a semiconductor chip, a film adhesive is used as a die attach film.

The film adhesive is precut according to the intended use (for example, according to the shape of the adherend), and a laminate or the like (for example, a laminate of a film adhesive and a dicing film) to which the film adhesive is bonded is also precut according to the intended use. When such precut processing is performed, it has been proposed that the film adhesive is irradiated with light, and high-accuracy precut processing is performed while the position and shape of the film adhesive are sensed by an optical sensor. However, when the film adhesive is transparent, sensing by an optical sensor is difficult. In order to cope with such a problem, for example, Patent Literature 1 proposes that a light transmittance adjusting component such as a dye or a pigment is blended in a film adhesive to lower the transparency of the film adhesive.

### CITATION LIST

### PATENT LITERATURES

Patent Literature 1: JP-A-2011-111530 ("JP-A" means an unexamined published Japanese patent application)

### SUMMARY OF INVENTION

### TECHNICAL PROBLEM

However, as described in Patent Literature 1, when a light transmittance adjusting component such as a pigment is blended in a film adhesive, the light transmittance adjusting component remains as it is in a cured product even after the film adhesive is cured. Therefore, the transparency remains impaired even after curing, and thus is not suitable, for example, as an adhesive for bonding a transparent protective film of an image sensor. In addition, a light transmittance adjusting component such as a pigment may act in a direction of decreasing the adhesive strength to impair a desired strong adhesive strength.

The present invention provides a film adhesive that has suppressed transparency before being used as an adhesive (before being cured), and thus enables sensing of the position and the shape of the film adhesive by an optical sensor, and as a result, can be precut with high accuracy, and functions as a transparent film cured product exhibiting high transparency and strong adhesive strength in a state of being used as an adhesive (after being thermally cured).

### SOLUTION TO PROBLEM

The above problems of the present invention have been solved by the following means.
[1] A film adhesive containing:
   an epoxy resin (A);
   an epoxy resin curing agent (B); and
   a phenoxy resin (C),

   wherein a content of the epoxy resin curing agent (B) in the film adhesive is 0.30 to 12.0 mass%; and
   wherein a light transmittance T1 of the film adhesive at a wavelength of 400 nm is 90% or less, a light transmittance T2 of a cured product obtained by thermally curing the film adhesive at a wavelength of 400 nm is 85% or more, and T1 < T2 is satisfied.
[2] The film adhesive described in [1],
   wherein the epoxy resin curing agent (B) is a powder having a particle diameter at 90% cumulative distribution frequency (d90) of 20.0 µm or less; and
   wherein the epoxy resin curing agent (B) is dispersed in the film adhesive.
[3] The film adhesive agent described in [1] or [2], having a thickness of 1 to 20 µm.
[4] The film adhesive described in any one of [1] to [3], containing no coloring agent.
[5] The film adhesive described in any one of [1] to [4], containing no inorganic filler.
[6] A laminated film including a laminate of the film adhesive described in any one of [1] to [5] and a dicing film.
[7] A method of producing an electronic component, including:
   a first step of obtaining a laminate including a transparent film member, the film adhesive described in any one of [1] to [5], and a dicing film laminated in this order;
   a second step of integrally dicing the transparent film member and the film adhesive to obtain a transparent film chip with an adhesive layer on the dicing film;
   a third step of removing the dicing film from the adhesive layer and thermocompression-bonding the transparent film chip with an adhesive layer and another member constituting the electronic component with the adhesive layer interposed between the transparent film chip with an adhesive layer and the another member; and
   a fourth step of thermally curing the adhesive layer.
[8] An electronic component including a structural part in which a transparent film chip is incorporated into the electronic component via a thermally cured product of the film adhesive described in any one of [1] to [5],
[9] The electronic component described in [8], which is an image sensor.
[10] The electronic component described in [9], wherein the transparent film chip is incorporated as a protective film for a photodiode.

The numerical ranges indicated with the use of the term "to" in the present invention refer to ranges including the numerical values before and after the term "to" respectively as the lower limit and the upper limit.

In the present invention, an "A compound" means a "compound having an A skeleton". For example, a "dicyandiamide compound" means to include, in addition to dicyandiamide itself, a form in which at least a part of hydrogen atoms of dicyandiamide is substituted.

### ADVANTAGEOUS EFFECTS OF INVENTION

The film adhesive of the present invention has suppressed transparency before being used as an adhesive (before being cured), and thus enables sensing of the position and the shape of the film adhesive by an optical sensor. As a result, the film adhesive of the present invention can be precut with high accuracy, and functions as a transparent film cured product exhibiting high transparency and strong adhesive strength in a state of being used as an adhesive (after being thermally cured).

### BRIEF DESCRIPTION OF DRAWINGS

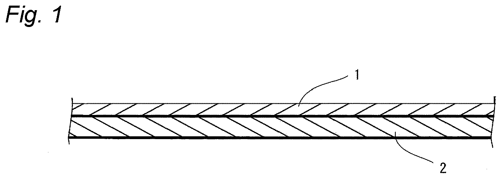

{FIG. 1}
FIG. 1 is a cross-sectional view schematically showing a structure of a film adhesive with a release film prepared in Examples.

### DESCRIPTION OF EMBODIMENTS

### [Film adhesive]

A film adhesive of the present invention contains an epoxy resin (A), an epoxy resin curing agent (B), and a phenoxy resin (C). In the film adhesive of the present invention, the content of the epoxy resin curing agent (B) in the film adhesive is 0.30 to 12.0 mass%.

The light transmittance T1 of the film adhesive of the present invention at a wavelength of 400 nm is 90% or less, and the light transmittance T2 of a cured product obtained by thermally curing the film adhesive of the present invention at a wavelength of 400 nm is 85% or more, and T1 < T2 is satisfied. Having such transmittance characteristics makes it possible to perform precut processing using an optical sensor with high efficiency, and provides a film adhesive exhibiting high transparency after a curing reaction. Therefore, a film adhesive having such transmittance characteristics exhibits excellent optical characteristics as an adhesive when a transparent member is incorporated into an electronic component or the like. When the film adhesive of the present invention is sensed by an optical sensor in precut processing or the like, the light wavelength is not limited to 400 nm. By controlling the light transmittance as described above using the wavelength of 400 nm as an index, the recognizability by the optical sensor in a wide wavelength range can be effectively enhanced.

First, each component contained in the film adhesive of the present invention will be described.

### <Epoxy resin (A)>

The epoxy resin (A) is a thermosetting resin having an epoxy group, and has an epoxy equivalent of 1,000 g/eq or less. The epoxy resin (A) may be liquid, solid, or semi-solid. The liquid in the present invention means that the softening point is less than 25°C. The solid means that the softening point is 60°C or more. The semi-solid means that the softening point is between the softening point of the liquid and the softening point of the solid (25°C or more and less than 60°C). As the epoxy resin (A) used in the present invention, the softening point is preferably 100°C or less from the viewpoint of obtaining a film adhesive that can reach low melt viscosity in a preferable temperature range (for example, 60 to 120°C). Incidentally, in the present invention, the softening point is a value measured by the softening point test (ring and ball) method (measurement condition: in accordance with JIS-K7234, 1986).

In the epoxy resin (A) used in the present invention, the epoxy equivalent is preferably 150 to 800 g/eq from the viewpoint of increasing the crosslinking density of a thermally cured product. Incidentally, in the present invention, the epoxy equivalent refers to the number of grams of a resin containing 1 gram equivalent of epoxy group (g/eq).

The mass average molecular weight of the epoxy resin (A) is usually preferably less than 10,000, and more preferably 5,000 or less. The lower limit is not particularly limited, but is practically 300 or more.

The mass average molecular weight is a value obtained by GPC (Gel Permeation Chromatography) analysis.

Examples of the skeleton of the epoxy resin (A) include a phenol novolac type, an orthocresol novolac type, a cresol novolac type, a dicyclopentadiene type, a biphenyl type, a fluorene bisphenol type, a triazine type, a naphthol type, a naphthalene diol type, a triphenylmethane type, a tetraphenyl type, a bisphenol A type, a bisphenol F type, a bisphenol AD type, a bisphenol S type, and a trimethylolmethane type. Among them, a triphenylmethane type, a bisphenol A type, a cresol novolac type, or an orthocresol novolac type is preferable from the viewpoint of obtaining a film adhesive having low resin crystallinity and good appearance. They may be used alone or two or more types thereof may be used in combination, and a combination of a triphenylmethane type and a bisphenol A type is preferable.

The content of the epoxy resin (A) is preferably 3 to 80 parts by mass, more preferably 30 to 70 parts by mass, and still more preferably 40 to 70 parts by mass based on 100 parts by mass of the total content of components constituting the film adhesive (specifically, components other than a solvent). By setting the content within the above preferred range, storage stability and transparency can be enhanced. Further, by adjusting the content to the preferable upper limit or less, generation of oligomer components can be suppressed, and the state of the film (for example, film tackiness) can be prevented from changing with small change in temperature.

### <Epoxy resin curing agent (B)>

The epoxy resin curing agent (B) is an important component for controlling the light transmittance defined in the present invention. The epoxy resin curing agent (B) is selected in consideration of the control of the light transmittance.

In order to control the light transmittance, the epoxy resin curing agent (B) is preferably a powder (powdery form) having a particle diameter at 90% cumulative distribution frequency (d90) of 20.0 µm or less. As used herein, the phenomenon that the epoxy resin curing agent (B) is a powder means that the epoxy resin curing agent (B) is in the form of solid particles at room temperature (25°C; the same applies to the following). The above d90 means a particle diameter at which the cumulative volume is 90% when the total volume of the particles is defined as 100% in the cumulative distribution as measured by the laser diffraction scattering method. Since the epoxy resin curing agent (B) is dispersed in the film adhesive as a predetermined powder, the light transmittance T1 at a wavelength of 400 nm can be reduced to 90% or less. In the epoxy resin curing agent (B), d90 is preferably 10.0 µm or less, more preferably 5.0 µm or less, even more preferably 3.0 µm or less, and also preferably 2.0 µm or less. In order to more reliably control the light transmittance T1 to 90% or less, d90 of the epoxy resin curing agent (B) is preferably 0.70 µm or more, more preferably 0.80 µm or more, and also preferably 0.90 µm or more.

As the epoxy resin curing agent (B), a commercially available product can be used, and pulverization treatment, sieving, and the like can be performed as necessary.

Even when the light transmittance T1 of the film adhesive at a wavelength of 400 nm is reduced to 90% or less using the powdery epoxy resin curing agent, the powdery epoxy resin curing agent reacts with the resin component in the film while being melted or the like at a high temperature in the thermal curing reaction, so that transparency after thermal curing can be enhanced. That is, it is possible to exhibit optical characteristics in which transparency is lower before thermal curing and transparency is enhanced after thermal curing.

As described above, the powdery epoxy resin curing agent (B) is preferably present in the form of powder (particulate form) also in the film adhesive. That is, the powdery epoxy resin curing agent (B) is preferably dispersed as fine solid particles in the film adhesive. In order to create such a state, the powdery epoxy resin curing agent preferably has low solvent solubility at 25°C. For example, when the solubility of the epoxy resin curing agent in 100 g of methyl ethyl ketone is less than 0.05 g (preferably less than 0.02 g, more preferably less than 0.01 g) at 25°C, the epoxy resin curing agent can be more reliably present in the form of fine particles in a varnish or film adhesive for forming a film adhesive, thus making it easy to realize a desired reduction in transparency. The solubility in methyl ethyl ketone is an index of the solubility of the epoxy resin curing agent in the film adhesive regardless of whether methyl ethyl ketone is used for the varnish for forming a film adhesive.

Conversely, when the solubility in methyl ethyl ketone is high, it is difficult to enhance the transparency after the curing reaction even if the transparency of the film adhesive can be reduced to 90% or less. In addition, when the epoxy resin curing agent does not exist in a particulate form in the film adhesive, even if the transparency of the film adhesive is 90% or less, the recognizability by an optical sensor tends to be poor.

Examples of the epoxy resin curing agent (B) include amines, acid anhydrides, and polyhydric phenols. From the viewpoint of the storage stability of the film adhesive, it is preferable to use a latent curing agent. Examples of the latent curing agent include a dicyandiamide compound, an imidazole compound, a curing catalyst composite-based polyhydric phenol compound, a hydrazide compound, a boron trifluoride-amine complex, an amine imide compound, a polyamine salt, a modified product thereof, and those of a microcapsule type. They may be used alone or two or more types thereof may be used in combination. Among them, it is preferable to use at least one type of a dicyandiamide compound, an imidazole compound, and a hydrazide compound.

The content of the epoxy resin curing agent (B) in the film adhesive of the present invention is 0.30 to 12.0 mass% from the viewpoint of controlling the light transmittances T1 and T2 to desired levels while imparting sufficient curability. The content is also preferably 0.40 to 12.0 mass%, also preferably 0.50 to 11.0 mass%, and also preferably 0.55 to 10.0 mass%.

The content of the epoxy resin curing agent (B) based on 100 parts by mass of the epoxy resin (A) is preferably 0.5 to 50 parts by mass, more preferably 1 to 40 parts by mass, even more preferably 2 to 30 parts by mass, and even more preferably 3 to 25 parts by mass from the viewpoint of exhibiting sufficient curing rate.

### <Phenoxy resin (C)>

The phenoxy resin (C) is a component that suppresses film tackiness at normal temperature (25°C) and imparts film formation property (film formability) when a film adhesive is formed.

The physical properties of the phenoxy resin (C) are not particularly limited. For example, a phenoxy resin having an elastic modulus at room temperature (25°C) of 500 MPa or more and 2,000 MPa or less can be used.

The mass average molecular weight of the phenoxy resin (C) is usually 10,000 or more. The upper limit is not particularly limited, but is practically 5,000,000 or less.

The mass average molecular weight of the phenoxy resin (C) is determined by GPC (Gel Permeation Chromatography) in terms of polystyrene.

The glass transition temperature (Tg) of the phenoxy resin (C) is preferably less than 120°C, more preferably less than 100°C, and more preferably less than 90°C. The lower limit is preferably 0°C or more, and more preferably 10°C or more.

The glass transition temperature of the phenoxy resin (C) is a glass transition temperature measured by DSC (Differential Scanning Calorimetry) at temperature elevation rate of 10°C/min.

The film adhesive of the present invention contains at least one type of phenoxy resin as the phenoxy resin (C).

Note that as used herein, the phenoxy resin (C) is one having an epoxy equivalent (mass of resin per equivalent of epoxy group) of more than 1,000 g/eq. Specifically, a resin having an epoxy equivalent of 1,000 g/eq or less even though having a phenoxy resin structure is classified as the epoxy resin (A).

The phenoxy resin (C) can be obtained by a reaction of a bisphenol or biphenol compound with epihalohydrin such as epichlorohydrin, or a reaction of liquid epoxy resin with a bisphenol or biphenol compound.

In any of the reactions, the bisphenol or biphenol compound is preferably a compound represented by the following formula (A).

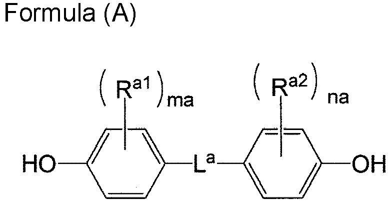

In the formula (A), L^{a} designates a single bond or divalent linking group, and R^{a1} and R^{a2} each independently designate a substituent. ma and na each independently designate an integer of 0 to 4.

In L^{a}, a divalent linking group is preferably an alkylene group, a phenylene group, -O-, -S-, -SO-, -SO₂-, or a group in which an alkylene group and a phenylene group are combined.

The number of carbon atoms of the alkylene group is preferably 1 to 10, more preferably 1 to 6, even more preferably 1 to 3, particularly preferably 1 or 2, and most preferably 1.

The alkylene group is preferably -C(R^{α})(R^{β})-, and here, R^{α} and R^{β} each independently designate a hydrogen atom, an alkyl group, and an aryl group. R^{α} and R^{β} may be bonded to each other to form a ring. R^{α} and R^{β} are preferably a hydrogen atom or an alkyl group (for example, methyl, ethyl, isopropyl, n-propyl, n-butyl, isobutyl, hexyl, octyl, or 2-ethylhexyl). The alkylene group is, in particular, preferably -CH₂-, -CH(CH₃)-, or C(CH₃)₂-, more preferably -CH₂- or -CH(CH₃)-, and even more preferably -CH₂-.

The number of carbon atoms of the phenylene group is preferably 6 to 12, more preferably 6 to 8, and even more preferably 6. Examples of the phenylene group include p-phenylene, m-phenylene, and o-phenylene. Among these, p-phenylene or m-phenylene is preferable.

The group in which an alkylene group and a phenylene group are combined is preferably an alkylene-phenylene-alkylene group, and more preferably -C(R^{α})(R^{β})-phenylene-C(R^{α})(R^{β})-.

The ring formed by bonding of R^{α} and R^{β} is preferably a 5- or 6-membered ring, more preferably a cyclopentane ring or a cyclohexane ring, and even more preferably a cyclohexane ring.

L^{a} is preferably a single bond, an alkylene group, -O-, or -SO₂-, and more preferably an alkylene group.

R^{a1} and R^{a2} are preferably an alkyl group, an aryl group, an alkoxy group, an alkylthio group, or a halogen atom, more preferably an alkyl group, an aryl group, or a halogen atom, and even more preferably an alkyl group.

ma and na are preferably 0 to 2, more preferably 0 or 1, and even more preferably 0.

Examples of the bisphenol or biphenol compound include bisphenol A, bisphenol AD, bisphenol AP, bisphenol AF, bisphenol B, bisphenol BP, bisphenol C, bisphenol E, bisphenol F, bisphenol G, bisphenol M, bisphenol S, bisphenol P, bisphenol PH, bisphenol TMC, bisphenol Z, 4,4'-biphenol, 2,2'-dimethyl-4,4'-biphenol, 2,2',6,6'-tetramethyl-4,4'-biphenol, and cardo skeleton type bisphenol. Bisphenol A, bisphenol AD, bisphenol C, bisphenol E, bisphenol F, or 4,4'-biphenol is preferable, bisphenol A, bisphenol E, or bisphenol F is more preferable, and bisphenol A is particularly preferable.

The liquid epoxy resin is preferably diglycidyl ether of an aliphatic diol compound, and is more preferably a compound represented by the following formula (B).

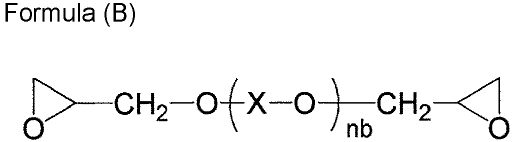

In the formula (B), X designates an alkylene group, and nb designates an integer of 1 to 10.

The number of carbon atoms of the alkylene group is preferably 2 to 10, more preferably 2 to 8, even more preferably 3 to 8, particularly preferably 4 to 6, and most preferably 6.

Examples of the alkylene group include ethylene, propylene, butylene, pentylene, hexylene, and octylene. Ethylene, trimethylene, tetramethylene, pentamethylene, heptamethylene, hexamethylene, or octamethylene is preferable.

nb is preferably 1 to 6, more preferably 1 to 3, and even more preferably 1.

Here, when nb is 2 to 10, X is preferably ethylene or propylene, and more preferably ethylene.

Examples of the aliphatic diol compound in diglycidyl ether include ethylene glycol, propylene glycol, diethylene glycol, triethylene glycol, polyethylene glycol, 1,3-propanediol, 1,4-butanediol, 1,5-heptanediol, 1,6-hexanediol, 1,7-pentanediol, and 1,8-octanediol.

In the above reaction, the phenoxy resin is a phenoxy resin obtained by reacting a single bisphenol or biphenol compound, or aliphatic diol compound, and may be a phenoxy resin obtained by mixing and reacting two or more types of bisphenol or biphenol compound, or aliphatic diol compound. For example, a reaction of diglycidyl ether of 1,6-hexanediol with a mixture of bisphenol A and bisphenol F is exemplified.

The phenoxy resin (C) in the present invention is preferably a phenoxy resin obtained by a reaction of a liquid epoxy resin with a bisphenol or biphenol compound, and more preferably a phenoxy resin having a repeating unit represented by the following formula (I).

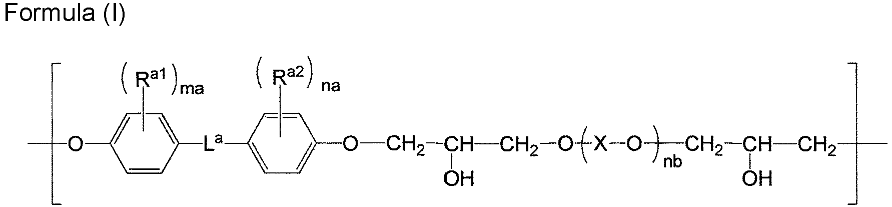

In the formula (I), L^{a}, R^{a1}, R^{a2}, ma, and na are synonymous with L^{a}, R^{a1}, R^{a2}, ma, and na in the formula (A), and the preferable ranges are also the same. X and nb are synonymous with X and nb in the formula (B), and the preferable ranges are also the same.

In the present invention, a polymer of bisphenol A and diglycidyl ether of 1,6-hexanediol is preferable among these substances.

Now, focus on the skeleton of the phenoxy resin, in the present invention, a bisphenol A type phenoxy resin or a bisphenol A/F type copolymerized phenoxy resin may be preferably used. In addition, a low-elastic high-heat-resistant phenoxy resin may be preferably used.

The mass average molecular weight of the phenoxy resin (C) is more preferably 10,000 to 100,000.

Further, the amount of epoxy group remaining in a small amount in the phenoxy resin (C) is preferably more than 5,000 g/eq in epoxy equivalent.

The phenoxy resin (C) may be synthesized by the above method, or a commercially available product may be used. Examples of the commercially available product include 1256 (bisphenol A type phenoxy resin, manufactured by Mitsubishi Chemical Corporation), YP-50 (bisphenol A type phenoxy resin, manufactured by NSCC Epoxy Manufacturing Co., Ltd.), YP-70 (bisphenol A/F type phenoxy resin, manufactured by NSCC Epoxy Manufacturing Co., Ltd.), FX-316 (bisphenol F type phenoxy resin, manufactured by NSCC Epoxy Manufacturing Co., Ltd.), FX-280S (cardo skeleton type phenoxy resin, manufactured by NSCC Epoxy Manufacturing Co., Ltd.), 4250 (bisphenol A type/F type phenoxy resin, manufactured by Mitsubishi Chemical Corporation), and FX-310 (low-elastic high-heat-resistant phenoxy resin, manufactured by NSCC Epoxy Manufacturing Co., Ltd.).

The proportion of the phenoxy resin (C) in the total content of the epoxy resin (A) and the phenoxy resin (C) is 10 to 60 mass%, preferably 20 to 50 mass%, preferably 30 to 50 mass%, and preferably 35 to 50 mass%.

### <Other components>

The film adhesive of the present invention may contain a polymer compound in addition to the epoxy resin (A), the epoxy resin curing agent (B), and the phenoxy resin (C) as long as the definition of the present invention is satisfied and the effects of the present invention are not impaired.

Examples of the polymer compound include natural rubber, butyl rubber, isoprene rubber, chloroprene rubber, silicone rubber, an ethylene-vinyl acetate copolymer, an ethylene-(meth)acrylic acid copolymer, an ethylene-(meth)acrylic acid ester copolymer, polybutadiene resin, polycarbonate resin, thermoplastic polyimide resin, polyamide resins such as 6-nylon and 6,6-nylon, (meth)acrylic resin, polyester resins such as polyethylene terephthalate and polybutylene terephthalate, polyamideimide resin, and fluororesin. These polymer compounds may be used alone, or in combination of two or more types thereof.

The total content of the epoxy resin (A) and the phenoxy resin (C) contained in the film adhesive of the present invention is preferably 50 mass% or more, more preferably 60 mass% or more, even more preferably 70 mass% or more, and also preferably 80 mass% or more.

The film adhesive of the present invention may further contain, for example, an ion trapping agent (ion capturing agent), a curing catalyst, a viscosity adjusting agent, an antioxidant, a flame retardant, a coloring agent, and an inorganic filler as long as the requirements defined in the present invention are satisfied. The film adhesive of the present invention can contain, for example, other additives described in WO 2017/158994 A.

From the viewpoint of adhesion reliability, the film adhesive of the present invention preferably does not contain a coloring agent such as a dye or a pigment. In addition, the film adhesive of the present invention is preferably in the form not containing an inorganic filler.

### <Thickness of film adhesive>

The thickness of the film adhesive of the present invention is not particularly limited, and can be appropriately set according to the purpose. The thickness of the film adhesive of the present invention can be set to, for example, 1 to 30 µm, also preferably 1 to 25 µm, also preferably 1 to 20 µm, also preferably 2 to 20 µm, also preferably 3 to 20 µm, and also preferably 4 to 20 µm. The thickness of the film adhesive can be measured by a contact type linear gauge method (desk-top contact type thickness measurement apparatus).

### <Light transmittance of film adhesive>

The light transmittance T1 of the film adhesive of the present invention at a wavelength of 400 nm is 90% or less, and the light transmittance T2 of a cured product obtained by thermally curing the film adhesive at a wavelength of 400 nm is 85% or more, and T1 < T2 is satisfied. The light transmittance at a wavelength of 400 nm is parallel line transmittance, and is determined by the method described in Examples described later. The "cured product obtained by thermally curing the film adhesive" means a cured product obtained by curing the film adhesive by treatment at 150°C for 1 hour. In the present invention or the specification, when simply referred to as "film adhesive of the present invention" in the description of the characteristics of the film adhesive, it means a film adhesive before thermal curing. Specifically, the film adhesive of the present invention means a film adhesive which is not exposed to a temperature equal to or more than a temperature at which the epoxy resin is thermally cured after preparation of the film adhesive. The film adhesive of the present invention is preferably a film adhesive which is not exposed to a temperature condition at 25°C or more after preparation of the film adhesive. Note that the above descriptions are provided to clarify the characteristics of the film adhesive of the present invention, and the film adhesive of the present invention is not limited to one that is not exposed to a temperature condition at 25°C or more.

When the light transmittance T1 of the film adhesive of the present invention is 90% or less, it is possible to sense the position and shape of the film adhesive by an optical sensor, and to perform precut processing with high accuracy. The light transmittance T1 is also preferably 89% or less, also preferably 88% or less, also preferably 87% or less, and also preferably 86% or less. The light transmittance T1 is usually 60% or more, and more preferably 65% or more from the viewpoint of securing transparency after thermal curing.

When the light transmittance T2 is 85% or more, high transparency can be secured after thermal curing, and optical characteristics suitable for adhesion of a transparent protective film or the like can be exhibited as a transparent film cured product. The light transmittance T2 is preferably 87% or more, more preferably 88% or more, and even more preferably 90% or more. The light transmittance T2 is also preferably 92% or more, and also preferably 94% or more.

Further, in the film adhesive of the present invention, the light transmittance T2 is higher than the light transmittance T1. That is, the transparency is improved by thermal curing. That is, in the state of the film adhesive before thermal curing, it is possible to sense the position and shape of the film adhesive by an optical sensor and perform precut processing with high accuracy, and the transparency of the film adhesive is enhanced by thermal curing, and optical characteristics suitable for adhesion of a transparent protective film and the like of an image sensor and the like are exhibited.

### <Production of film adhesive>

The film adhesive of the present invention can be obtained by forming a film using a composition (composition for forming a film adhesive (varnish)) obtained by mixing components constituting the film adhesive at a temperature at which the epoxy resin (A) is practically not thermally cured. The order of mixing is not particularly limited. For example, resin components such as the epoxy resin (A) and the phenoxy resin (C) may be mixed together with a solvent, if necessary, and the epoxy resin curing agent (B) may then be mixed. In this case, the mixing in the presence of the epoxy resin curing agent (B) may be performed at a temperature at which the epoxy resin (A) is practically not thermally cured, and the mixing of the resin components in the absence of the epoxy resin curing agent (B) may be performed at a higher temperature.

The film formation using the composition for forming a film adhesive can be performed, for example, by applying the composition for forming a film adhesive onto a release-treated base film (also referred to as a release film), and drying the composition as necessary.

As the release film, any release film that functions as a cover film of an obtained film adhesive can be used, and a normal film can be appropriately employed. Examples thereof include release-treated polypropylene (PP), release-treated polyethylene (PE), and release-treated polyethylene terephthalate (PET).

A normal method can be appropriately employed as an application method, and examples thereof include methods using a roll knife coater, a gravure coater, a die coater, and a reverse coater.

The drying may be performed by removing the organic solvent from the composition for forming a film adhesive without substantially curing the epoxy resin (A) to obtain a film adhesive, and can be performed, for example, by holding the composition at a temperature of 80 to 150°C for 1 to 20 minutes.

The film adhesive of the present invention may be a form obtained by bonding the release film or the like to at least one surface of the film adhesive. In this case, the release film does not constitute the film adhesive of the present invention, but is regarded as a member laminated on the film adhesive of the present invention. That is, when the thickness of the film adhesive is described in the form obtained by bonding the release film or the like to at least one surface of the film adhesive, the thickness does not include the thickness of the base film. That is, in the present invention, the thickness of the film adhesive is the thickness of the layer derived from the composition for forming a film adhesive.

The film adhesive of the present invention may be a form obtained by cutting the film into an appropriate size, or a form obtained by winding the film into a roll form.

From the viewpoint of more reliably suppressing thermal curing of the epoxy resin (A), the film adhesive of the present invention is preferably stored under a temperature condition at 10°C or less before use.

As an example, the film adhesive of the present invention can be used as a form of a laminated film formed by laminating a film adhesive and a dicing film (dicing tape). A release film or the like may be further laminated on the laminated film. Using such a laminated film, for example, a transparent film member (adherend) such as a transparent protective film is firmly adhered to the film adhesive side of the laminated film, this is fixed via the dicing film, and the transparent film member can be cut (diced) into a desired size together with the film adhesive. As a result, a transparent film chip with an adhesive layer cut into a desired size can be obtained on the dicing film. Then, the transparent film chip with an adhesive layer is peeled off from the dicing film, and the transparent film chip can be incorporated into an electronic component via the adhesive layer. This incorporation of the transparent film chip into the electronic component is performed by thermocompression bonding or the like, and then the adhesive layer is thermally cured, whereby the transparency of the adhesive can be enhanced with the curing reaction.

For the condition of thermocompression bonding, thermocompression bonding is performed at a temperature at which the epoxy resin (A) is practically not thermally cured. As an example, the condition at a temperature of 70°C and a pressure of about 0.3 MPa is exemplified.

The thermal curing reaction may be performed at a temperature equal to or more than the thermal curing start temperature of the film adhesive of the present invention. The thermal curing start temperature varies depending on the types of the epoxy resin (A), the phenoxy resin (C), and the epoxy curing agent (B) to be used. The thermal curing start temperature is, although it cannot be said unconditionally, for example, preferably 100 to 180°C, and more preferably 140 to 180°C from the viewpoint of realizing short-time curing. When the temperature is less than the thermal curing start temperature, the thermal curing reaction does not sufficiently proceed, and the strength of the adhesive layer tends to decrease. On the other hand, when the temperature of the curing reaction is too high, the epoxy resin, the curing agent, the additive, and the like in the film adhesive tend to volatilize and foam during the curing reaction. Also, the time for curing treatment is preferably, for example, 10 to 120 minutes.

Regarding the above-described embodiment, according to the present invention, a method of producing an electronic component described below is provided.

A method of producing an electronic component, including:
a first step of obtaining a laminate including a transparent film member, the film adhesive according to the present invention, and a dicing film laminated in this order;
a second step of integrally dicing the transparent film member and the film adhesive to obtain a transparent film chip with an adhesive layer on the dicing film;
a third step of removing the dicing film from the adhesive layer and thermocompression-bonding the transparent film chip with an adhesive layer and another member with the adhesive layer interposed between the transparent film chip with an adhesive layer and the another member; and
a fourth step of thermally curing the adhesive layer.

Further, according to the present invention, the following electronic component is provided.

An electronic component including a structural part in which a transparent film chip is incorporated into the electronic component via a thermally cured product of the film adhesive according to the present invention.

In the present invention, the "transparent film chip" means a transparent film processed into a desired shape. The transparent film chip is typically produced by cutting a transparent film member such as a glass substrate or a transparent resin into a desired shape in order to be incorporated into an electronic component.

An example of the electronic component is an image sensor (imaging element). In this case, the transparent film chip incorporated in the electronic component is preferably a protective film for a photodiode.

Note that the above description describes a preferred embodiment of the film adhesive of the present invention, and the present invention is not limited to these embodiments at all except that it is defined in the present invention. Preferable examples of the electronic component include members used for optical devices such as an optical lens, an optical fiber, an optical waveguide, an optical isolator, and a semiconductor laser.

### EXAMPLES

The present invention will be described in more detail based on examples and comparative examples, but the present invention is not meant to be limited by the following embodiments.

In the following description, the room temperature means 25°C. Also, "MEK" is methyl ethyl ketone, and "PET" is polyethylene terephthalate.

As examples and comparative examples, a film adhesive with a release film shown in FIG. 1 was each prepared.

### [Example 1]

In a 1,000 ml separable flask, 80 parts by mass of an epoxy resin (trade name: 828, manufactured by Mitsubishi Chemical Corporation, bisphenol A type epoxy resin, epoxy equivalent: 190 g/eq, specific gravity: 1.17), 30 parts by mass of an epoxy resin (trade name: EPICLON 2050, manufactured by DIC Corporation, bisphenol A type epoxy resin, epoxy equivalent: 600 g/eq, softening point: 80°C), and 70 parts by mass of a phenoxy resin (trade name: 1256, manufactured by Mitsubishi Chemical Corporation, bisphenol A type phenoxy resin, epoxy equivalent: 7,500 g/eq) were heated with stirring together with MEK at a temperature of 110°C for 2 hours to obtain a resin varnish. Next, this resin varnish was transferred to another flask container, and 2.5 parts by mass of a crushed epoxy resin curing agent (trade name: DICY7, manufactured by Mitsubishi Chemical Corporation, dicyandiamide compound, particle diameter at 90% cumulative distribution frequency (d90): 0.95 µm, solubility in MEK at 25°C: less than 0.01 g/100 g-MEK) was added thereto. The mixture was stirred and mixed at room temperature for 1 hour, and then vacuum-defoamed to obtain a mixed varnish. Further, the obtained mixed varnish was applied onto a release-treated PET film (release film) having a thickness of 38 µm and then dried by heating at 130°C for 10 minutes to form a film adhesive layer having a length of 300 mm, a width of 300 mm, and a thickness of 5 µm. The resulting film adhesive with a release film was stored at 10°C or less. After the drying, the epoxy resin was not cured (hereinafter, the same applies to other Examples and Comparative Examples unless otherwise specified).

### [Example 2]

A film adhesive with a release film (thickness of the film adhesive: 10 µm) was obtained in the same manner as in Example 1 except that the blending amounts of each resin and the epoxy resin curing agent were changed as shown in the table below.

### [Example 3]

A film adhesive with a release film (thickness of the film adhesive: 10 µm) was obtained in the same manner as in Example 1 except that the blending amount of each resin was as shown in the table below, and the epoxy resin curing agent was changed to 1 part by mass of a crushed curing agent (trade name: N14, manufactured by Mitsubishi Chemical Corporation, a hydrazide compound, particle diameter at 90% cumulative distribution frequency (d90): 2.0 µm, solubility in MEK at 25°C: less than 0.01 g/100 g-MEK).

### [Example 4]

A film adhesive with a release film (thickness of the film adhesive: 10 µm) was obtained in the same manner as in Example 3 except that the blending amounts of each resin and the epoxy resin curing agent were changed as shown in the table below.

### [Example 5]

A film adhesive with a release film (thickness of the film adhesive: 20 µm) was obtained in the same manner as in Example 1 except that the blending amount of each resin was as shown in the table below, and the epoxy resin curing agent was changed to 15 part by mass of an uncrushed curing agent (trade name: DICY7, manufactured by Mitsubishi Chemical Corporation, particle diameter at 90% cumulative distribution frequency (d90): 15.0 µm, solubility in MEK at 25°C: less than 0.01 g/100 g-MEK).

### [Example 6]

A film adhesive with a release film (thickness of the film adhesive: 20 µm) was obtained in the same manner as in Example 1 except that the blending amount of each resin was as shown in the table below, and the epoxy resin curing agent was changed to 15 part by mass of an uncrushed curing agent (trade name: N14, manufactured by Mitsubishi Chemical Corporation, particle diameter at 90% cumulative distribution frequency (d90): 18.0 µm, solubility in MEK at 25°C: less than 0.01 g/100 g-MEK).

### [Comparative Example 1]

A film adhesive with a release film (thickness of the film adhesive: 5 µm) was obtained in the same manner as in Example 1 except that the blending amount of each resin was as shown in the table below, and the epoxy resin curing agent was changed to 5 parts by mass of an untreated curing agent (trade name: SI-150, manufactured by Sanshin Chemical Industry Co., Ltd., cationic polymerization initiator, solubility in MEK at 25°C: 10 g or more/100 g-MEK).

### [Comparative Example 2]

A film adhesive with a release film (thickness of the film adhesive: 5 µm) was prepared in the same manner as in Example 1 except that the blending amount of each resin was as shown in the table below, and the epoxy resin curing agent was changed to 5 parts by mass of a pigment (trade name: C.I. Pig Black 7, manufactured by Mitsubishi Chemical Corporation, solubility in MEK at 25°C: less than 0.01 g/100 g-MEK).

### [Comparative Example 3]

A film adhesive with a release film (thickness of the film adhesive: 5 µm) was obtained in the same manner as in Example 1 except that the blending amount of each resin was as shown in the table below, and the epoxy resin curing agent was not added.

### [Comparative Example 4]

A film adhesive with a release film (thickness of the film adhesive: 5 µm) was prepared in the same manner as in Example 1 except that the blending amounts of each resin and the curing agent were as shown in the table below.

### [Comparative Example 5]

A film adhesive with a release film (thickness of the film adhesive: 5 µm) was prepared in the same manner as in Example 1 except that the blending amounts of each resin and the curing agent were as shown in the table below.

### [Comparative Example 6]

A film adhesive with a release film (thickness of the film adhesive: 5 µm) was obtained in the same manner as in Example 1 except that the blending amount of each resin was as shown in the table below, the epoxy resin curing agent was changed to 35 parts by mass of an untreated curing agent (trade name: Milex XLC-LL, manufactured by Mitsui Chemicals, Inc., phenol compound, solubility in MEK at 25°C: 10 g or more/100 g-MEK), and 4.2 parts by mass of a pigment (trade name: C.I. Pig Black 7, manufactured by Mitsubishi Chemical Corporation, solubility in MEK at 25°C: less than 0.01 g/100 g-MEK) was further added.

### [Comparative Example 7]

A film adhesive with a release film (thickness of the film adhesive: 5 µm) was obtained in the same manner as in Example 1 except that the blending amount of each resin was as shown in the table below, and the epoxy resin curing agent was changed to 35 parts by mass of an untreated curing agent (trade name: Milex XLC-LL, manufactured by Mitsui Chemicals, Inc., phenol compound, solubility in MEK at 25°C: 10 g or more/100 g-MEK).

### [Comparative Example 8]

A film adhesive with a release film (thickness of the film adhesive: 20 µm) was obtained in the same manner as in Example 1 except that the type and blending amount of the resin were as shown in the table below, and the epoxy curing agent was changed to 24 parts by mass of a liquid curing agent (trade name: MH-700, manufactured by New Japan Chemical Co., Ltd., alicyclic acid anhydride, solubility in MEK at 25°C: 10 g or more/100 g-MEK).

The method of pulverizing the epoxy resin curing agent in each of the above Examples and Comparative Examples is as follows.

### <Crushing treatment of epoxy curing agent>

An epoxy resin curing agent was pulverized with a dry pulverizer (trade name: Dry burst parallel DB-180WP, manufactured by SUGINO MACHINE LIMITED) at a rotation speed of 5,000 rev/min for 3 hours.

The particle size distribution of the epoxy resin curing agent used in each of the above Examples and Comparative Examples was determined as follows.

### <Measurement of particle size distribution of epoxy resin curing agent>

A measurement sample was prepared by weighing 0.1 g of an epoxy resin curing agent and 9.9 g of MEK, and subjecting a mixture thereof to ultrasonic dispersion treatment for 5 minutes. The particle diameter at 90% cumulative distribution frequency (d90) of this measurement sample was determined from the cumulative curve of the volume fraction of the particle diameter in the particle size distribution measured by the laser diffraction scattering method (model: LMS-2000e, manufactured by Seishin Enterprise Co., Ltd.). The results are shown in Table 1.

For the film adhesive with a release film obtained in each of the above Examples and Comparative Examples, the transmittance of the film adhesive before and after thermal curing was determined as follows.

### <Measurement of transmittance>

The film adhesive on the release film was bonded to a glass plate by heating at 70°C, and then the release film was peeled off to obtain a glass sample with a film adhesive. Using the transmittance of the glass plate alone as a baseline, the parallel line transmittance of the film adhesive before and after thermal curing was measured with a spectrophotometer (spectrophotometer U-4100 type solid sample measurement system, manufactured by Hitachi High-Technologies Corporation). The conditions for the curing reaction were heat treatment at 150°C for 1 hour. Thus, the light transmittance of each film adhesive at a wavelength of 400 nm was determined.

For the film adhesive with a release film obtained in each of the above Examples and Comparative Examples, the recognizability by an optical sensor in precut processing was evaluated as follows.

### <Recognizability by optical sensor>

The film adhesive with a release film was cut into a circular shape having a diameter of 220 mm. A dicing film was laminated on the film adhesive side of the circular film adhesive with a release film at room temperature. Next, while sensing the dicing film located outside the circular film adhesive with a release film using an optical sensor (laser sensor, wavelength: 600 to 700 nm), the dicing film was precut into a circular shape having a diameter of 290 mm concentrically with the circular film adhesive with a release film (shape conforming to the shape of the wafer ring frame). In this precut processing, a difference in transmittance between a laminated portion of the circular film adhesive with a release film and the dicing film and a single layer portion of only the dicing film was recognized by the optical sensor, and a place where the circular film adhesive with a release film was bonded was grasped, whereby a predetermined position of the dicing film was cut. In each of Examples and Comparative Examples, precut processing was performed on 300 sheets of dicing films, and the processing success rate (%) was evaluated.

For the film adhesive with a release film obtained in each of the above Examples and Comparative Examples, the uniform dispersibility of the epoxy resin curing agent in the film adhesive was evaluated as follows using the appearance by microscopic observation as an index.

### <Appearance of film adhesive>

The appearance of the film adhesive formed on the release film was observed with a transmission type optical microscope. Four visual fields (four different regions, size of one region: 50 mm × 50 mm) were randomly observed, and the number of visual fields where lumps shown in the following evaluation criteria were observed in plan view was examined and evaluated. Thereby, the uniform dispersibility of the epoxy resin curing agent can be evaluated.

### -Evaluation criteria-

A: The number of visual fields where one or more lumps having a maximum dimension of 1.5 times or more d90 of the curing agent used were observed was 0.
B: The number of visual fields where one or more lumps having a maximum dimension of 1.5 times or more d90 of the curing agent used were observed was 1.
C: The number of visual fields where one or more lumps having a maximum dimension of 1.5 times or more d90 of the curing agent used were observed was 2 or more.

The "maximum dimension" means the length of the long side of the rectangle having the minimum area circumscribing the lump.

Comparative Examples 2 and 6 were evaluated based on "d90 of the used pigment" instead of the "d90 of the used curing agent" in the above evaluation criteria. In Comparative Examples 7 and 8 in which the powdery curing agent or the pigment was not used, no lump was observed, and therefore evaluation A was given.

For the film adhesive with a release film obtained in each of the above Examples and Comparative Examples, the adhesion reliability after the film adhesive was thermocompression-bonded and then thermally cured was evaluated as follows using the shear peeling strength as an index.

### <Adhesion reliability>

The film adhesive with a release film obtained in each of Examples and Comparative Examples was first thermocompression-bonded to one surface of a dummy silicon wafer (size: 8 inch, thickness: 350 µm) by using a manual laminator (trade name: FM-114, manufactured by Technovision, Inc.) at a temperature of 70°C and a pressure of 0.3 MPa. Thereafter, the release film was peeled off from the film adhesive. Then, a dicing film (trade name: K-13, manufactured by Furukawa Electric Co., Ltd.) and a dicing frame (trade name: DTF2-8-1H001, manufactured by DISCO Corporation) were pressure-bonded on a surface of the film adhesive opposite to the dummy silicon wafer, by using the same manual laminator at room temperature and a pressure of 0.3 MPa. Next, dicing (cutting) was performed from the dummy silicon wafer side in the thickness direction of the film adhesive to the depth reaching the entire thickness of the film adhesive so as to have a size of 2 mm × 2 mm by using a dicing apparatus (trade name: DFD-6340, manufactured by DISCO Corporation) equipped with two axes of dicing blades (Z1: NBC-ZH2050 (27HEDD), manufactured by DISCO Corporation/Z2: NBC-ZH127F-SE(BC), manufactured by DISCO Corporation), thus obtaining a dummy chip with an adhesive on the dicing film.

Next, the dummy chip with an adhesive was picked up from the dicing film by a die bonder (trade name: DB-800, manufactured by Hitachi High-Technologies Corporation). The surface on the adhesive side of the dummy chip with an adhesive and a dummy silicon wafer (thickness: 700 µm) as an adherend substrate were thermocompression-bonded under the conditions of 120°C, a pressure of 0.1 MPa (load: 400 gf), and 1.0 seconds. The adhesive was then thermally cured by heating at a temperature of 150°C for 1 hour. The adhesive strength between the adherend substrate and the dummy chip bonded via the thermally cured product of the adhesive was evaluated using the shear peeling strength as an index. The shear peeling strength was measured with a universal bond tester (trade name: series 4000PXY, manufactured by Nordson Advanced Technology Inc.).

### -Evaluation criteria-

A: Shear peeling strength is 20 MPa or more.
B: Shear peeling strength is 5 MPa or more and less than 20 MPa.
C: Shear peeling strength is less than 5 MPa.

The above results are collectively shown in the following table. In the table below, the numerical values indicating the blending amounts of the liquid epoxy resin, the solid epoxy resin, the phenoxy resin, the acrylic resin, the epoxy resin curing agent, and the pigment are parts by mass.

**[Table 1]**

| | | | Ex. 1 | Ex. 2 | Ex. 3 |
|---|---|---|---|---|---|
| Liquid epoxy resin | 828 (Mitsubishi Chemical Corporation) | | 80 | 70 | 70 |
| Solid epoxy resin | 2050 (DIC Corporation) | | 30 | 50 | 30 |
| Phenoxy resin | 1256 (Mitsubishi Chemical Corporation) | | 70 | 60 | 80 |
| Acrylic resin | SG-P3 (Nagase ChemteX Corporation) | | | | |
| Epoxy resin curing agent | DICY7 crushed product | d90: 0.95 µm | 2.5 | 20 | |
| | N14 crushed product | d90: 2.0 µm | | | 1 |
| | DICY7 uncrushed product | d90: 15.0 µm | | | |
| | N14 uncrushed product | d90: 18.0 µm | | | |
| | SI-150 (Sanshin Chemical Industry Co., Ltd.) | | | | |
| | Milex XLC-LL (Mitsui Chemicals, Inc.) | | | | |
| | MH-700 (New Japan Chemical Co., Ltd.) | | | | |
| Pigment | C.I. Pig Black 7 (manufactured by Mitsubishi Chemical Corporation) | | | | |
| Thickness of film adhesive [um] | | | 5 | 10 | 10 |
| Light transmittance T1 (%) of film adhesive at wavelength of 400 nm | | | 90 | 77 | 89 |
| Light transmittance T2 (%) of thermal curing reaction product at wavelength of 400 nm | | | 97 | 94 | 96 |
| Recognizability by optical sensor [processing success rate%] | | | 100 | 100 | 100 |
| Appearance of film adhesive | | | A | A | A |
| Adhesion reliability | | | A | A | A |

| | | | | | |
|---|---|---|---|---|---|
| Remarks: 'Ex.' means Example according to this invention. | | | | | |

| | | | Ex. 4 | Ex. 5 | Ex. 6 |
|---|---|---|---|---|---|
| Liquid epoxy resin | 828 (Mitsubishi Chemical Corporation) | | 90 | 65 | 80 |
| Solid epoxy resin | 2050 (DIC Corporation) | | 5 | 25 | 25 |
| Phenoxy resin | 1256 (Mitsubishi Chemical Corporation) | | 85 | 90 | 75 |
| Acrylic resin | SG-P3 (Nagase ChemteX Corporation) | | | | |
| Epoxy resin curing agent | DICY7 crushed product | d90: 0.95 µm | | | |
| | N14 crushed product | d90: 2.0 µm | 20 | | |
| | DICY7 uncrushed product | d90: 15.0 µm | | 15 | |
| | N14 uncrushed product | d90: 18.0 µm | | | 15 |
| | SI-150 (Sanshin Chemical Industry Co., Ltd.) | | | | |
| | Milex XLC-LL (Mitsui Chemicals, Inc.) | | | | |
| | MH-700 (New Japan Chemical Co., Ltd.) | | | | |
| Pigment | C.I. Pig Black 7 (manufactured by Mitsubishi Chemical Corporation) | | | | |
| Thickness of film adhesive [um] | | | 10 | 20 | 20 |
| Light transmittance T1 (%) of film adhesive at wavelength of 400 nm | | | 75 | 68 | 65 |
| Light transmittance T2 (%) of thermal curing reaction product at wavelength of 400 nm | | | 94 | 92 | 92 |
| Recognizability by optical sensor [processing success rate%] | | | 100 | 100 | 100 |
| Appearance of film adhesive | | | A | C | C |
| Adhesion reliability | | | A | B | B |

| | | | | | |
|---|---|---|---|---|---|
| Remarks: 'Ex.' means Example according to this invention. | | | | | |

| | | | C Ex. 1 | C Ex. 2 | C Ex. 3 | C Ex. 4 |
|---|---|---|---|---|---|---|
| Liquid epoxy resin | 828 (Mitsubishi Chemical Corporation) | | 90 | 85 | 85 | 80 |
| Solid epoxy resin | 2050 (DIC Corporation) | | 0 | 30 | 20 | 30 |
| Phenoxy resin | 1256 (Mitsubishi Chemical Corporation) | | 90 | 65 | 75 | 70 |
| Acrylic resin | SG-P3 (Nagase ChemteX Corporation) | | | | | |
| Epoxy resin curing agent | DICY7 crushed product | d90: 0.95 µm | | | | 0.5 |
| | N14 crushed product | d90: 2.0 µm | | | | |
| | DICY7 uncrushed product | d90: 15.0 µm | | | | |
| | N14 uncrushed product | d90: 18.0 µm | | | | |
| | SI-150 (Sanshin Chemical Industry Co., Ltd.) | | 5 | | | |
| | Milex XLC-LL (Mitsui Chemicals, Inc.) | | | | | |
| | MH-700 (New Japan Chemical Co., Ltd.) | | | | | |
| Pigment | C.I. Pig Black 7 (manufactured by Mitsubishi Chemical Corporation) | | | 5 | | |
| Thickness of film adhesive [um] | | | 5 | 5 | 5 | 5 |
| Light transmittance T1 (%) of film adhesive at wavelength of 400 nm | | | 99 | 40 | 99 | 96 |
| Light transmittance T2 (%) of thermal curing reaction product at wavelength of 400 nm | | | 99 | 40 | 99 | 98 |
| Recognizability by optical sensor [processing success rate%] | | | 0 | 100 | 0 | 0 |
| Appearance of film adhesive | | | A | C | A | A |
| Adhesion reliability | | | A | C | C | c |

| | | | | | | |
|---|---|---|---|---|---|---|
| Remarks: 'CEx.' means Comparative Example. | | | | | | |

| | | | C Ex. 5 | C Ex. 6 | C Ex. 7 | C Ex. 8 |
|---|---|---|---|---|---|---|
| Liquid epoxy resin | 828 (Mitsubishi Chemical Corporation) | | 50 | 65 | 65 | 26 |
| Solid epoxy resin | 2050 (DIC Corporation) | | 40 | | | |
| Phenoxy resin | 1256 (Mitsubishi Chemical Corporation) | | 90 | 250 | 250 | |
| Acrylic resin | SG-P3 (Nagase ChemteX Corporation) | | | | | 100 |
| Epoxy resin curing agent | DICY7 crushed product | d90: 0.95 µm | 25 | | | |
| | N14 crushed product | d90: 2.0 µm | | | | |
| | DICY7 uncrushed product | d90: 15.0 µm | | | | |
| | N14 uncrushed product | d90: 18.0 µm | | | | |
| | SI-150 (Sanshin Chemical Industry Co., Ltd.) | | | | | |
| | Milex XLC-LL (Mitsui Chemicals, Inc.) | | | 35 | 35 | |
| | MH-700 (New Japan Chemical Co., Ltd.) | | | | | 24 |
| Pigment | C.I. Pig Black 7 (manufactured by Mitsubishi Chemical Corporation) | | | 4.2 | | |
| Thickness of film adhesive [um] | | | 5 | 5 | 5 | 20 |
| Light transmittance T1 (%) of film adhesive at wavelength of 400 nm | | | 60 | 55 | 88 | 80 |
| Light transmittance T2 (%) of thermal curing reaction product at wavelength of 400 nm | | | 75 | 45 | 80 | 75 |
| Recognizability by optical sensor [processing success rate%] | | | 100 | 100 | 88 | 0 |
| Appearance of film adhesive | | | A | C | A | A |
| Adhesion reliability | | | C | C | A | C |

| | | | | | | |
|---|---|---|---|---|---|---|
| Remarks: 'CEx.' means Comparative Example. | | | | | | |

As shown in the above table, when the light transmittance T1 of the film adhesive (before thermal curing) at a wavelength of 400 nm was higher than that specified in the present invention, the recognizability by an optical sensor was poor, and the success rate of the precut processing was significantly poor (Comparative Examples 1, 3, and 4). When a pigment is blended in the film adhesive, the light transmittance T1 of the film adhesive (before thermal curing) at a wavelength of 400 nm greatly decreases, and as a result, the recognizability by an optical sensor can be enhanced. However, the blending of the pigment resulted in impairing the uniform dispersibility of the adhesive and impairing the adhesion reliability (Comparative Examples 2 and 6). In addition, depending on the type and blending amount of the curing agent to be used and the type of the resin to be blended, the film adhesive could not exhibit sufficient transparency after the curing reaction (Comparative Examples 5, 7, and 8).

On the other hand, it was also found that in the film adhesives of Examples 1 to 6, which satisfy the definitions of the present invention, the light transmittance T1 at a wavelength of 400 nm can be reduced to 90% or less by blending an epoxy resin curing agent without using a pigment, and thus these film adhesives are excellent in recognizability by an optical sensor regardless of the wavelength, and the transparency of these film adhesives is improved after curing, and thus the film adhesives exhibit excellent transparency.

Having described our invention as related to the present embodiments, it is our intention that the invention not be limited by any of the details of the description, unless otherwise specified, but rather be construed broadly within its spirit and scope as set out in the accompanying claims.

This application claims a priority on Patent Application No. 2021-135624 filed in Japan on August 23, 2021, which is herein incorporated by reference as a part of the present specification.

### REFERENCE SIGNS LIST

- 1: Film adhesive
- 2: Release film

## Claims

1. A film adhesive comprising:
an epoxy resin (A);
an epoxy resin curing agent (B); and
a phenoxy resin (C),
wherein a content of the epoxy resin curing agent (B) in the film adhesive is 0.30 to 12.0 mass%; and
wherein a light transmittance T1 of the film adhesive at a wavelength of 400 nm is 90% or less, a light transmittance T2 of a cured product obtained by thermally curing the film adhesive at a wavelength of 400 nm is 85% or more, and T1 < T2 is satisfied.

2. The film adhesive according to claim 1,
wherein the epoxy resin curing agent (B) is a powder having a particle diameter at 90% cumulative distribution frequency (d90) of 20.0 µm or less; and
wherein the epoxy resin curing agent (B) is dispersed in the film adhesive.

3. The film adhesive agent according to claim 1 or 2, having a thickness of 1 to 20 µm.

4. The film adhesive according to any one of claims 1 to 3, comprising no coloring agent.

5. The film adhesive according to any one of claims 1 to 4, comprising no inorganic filler.

6. A laminated film comprising a laminate of the film adhesive according to any one of claims 1 to 5 and a dicing film.

7. A method of producing an electronic component, comprising:
a first step of obtaining a laminate including a transparent film member, the film adhesive according to any one of claims 1 to 5, and a dicing film laminated in this order;
a second step of integrally dicing the transparent film member and the film adhesive to obtain a transparent film chip with an adhesive layer on the dicing film;
a third step of removing the dicing film from the adhesive layer and thermocompression-bonding the transparent film chip with an adhesive layer and another member constituting the electronic component with the adhesive layer interposed between the transparent film chip with an adhesive layer and the another member; and
a fourth step of thermally curing the adhesive layer.

8. An electronic component comprising a structural part in which a transparent film chip is incorporated into the electronic component via a thermally cured product of the film adhesive according to any one of claims 1 to 5.

9. The electronic component according to claim 8, which is an image sensor.

10. The electronic component according to claim 9, wherein the transparent film chip is incorporated as a protective film for a photodiode.
